(19) Europäisches Patentamt
European Patent Office
Office européen des brevets

(11) **EP 3 857 690 B1**

(12) **EUROPÄISCHE PATENTSCHRIFT**

(45) Veröffentlichungstag und Bekanntmachung des Hinweises auf die Patenterteilung:
**29.03.2023 Patentblatt 2023/13**

(21) Anmeldenummer: **19812691.4**

(22) Anmeldetag: **12.11.2019**

(51) Internationale Patentklassifikation (IPC):
*H02M 1/32* (2007.01)     *H02M 1/08* (2006.01)
*H03K 17/082* (2006.01)

(52) Gemeinsame Patentklassifikation (CPC):
**H02M 1/32; H02M 1/08; H03K 17/0822;**
**H03K 17/0828;** H03K 2217/0027

(86) Internationale Anmeldenummer:
**PCT/EP2019/081056**

(87) Internationale Veröffentlichungsnummer:
**WO 2020/099426 (22.05.2020 Gazette 2020/21)**

(54) **ÜBERSTROMERKENNUNG EINES ELEKTRONISCHEN SCHALTERS**

OVER-CURRENT DETECTION OF AN ELECTRONIC SWITCH

DÉTECTION D'UN COURANT DE SURCHARGE D'UN COMMUTATEUR ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.11.2018 EP 18206763**

(43) Veröffentlichungstag der Anmeldung:
**04.08.2021 Patentblatt 2021/31**

(73) Patentinhaber: **Siemens Aktiengesellschaft**
**80333 München (DE)**

(72) Erfinder:
• **HANDT, Karsten**
**92348 Berg (DE)**
• **HÄNSEL, Stefan**
**91056 Erlangen (DE)**

(74) Vertreter: **Siemens Patent Attorneys**
**Postfach 22 16 34**
**80506 München (DE)**

(56) Entgegenhaltungen:
EP-A1- 3 118 995          EP-A2- 2 444 817
DE-A1-102015 105 192      DE-C1- 10 210 181
JP-A- 2004 312 907        JP-A- 2017 011 612
KR-B1- 101 085 864        US-A1- 2013 063 188
US-A1- 2015 326 222       US-B1- 6 313 513

• CHRISTIAN KLUMPNER ET AL: "New Solutions for a Low-Cost Power Electronic Building Block for Matrix Converters", IEEE TRANSACTIONS ON INDUSTRIAL ELECTRONICS, IEEE SERVICE CENTER, PISCATAWAY, NJ, USA, Bd. 49, Nr. 2, 1. April 2002 (2002-04-01), XP011073693, ISSN: 0278-0046
• EMPRINGHAM LEE ET AL: "Design Challenges in the Use of Silicon Carbide JFETs in Matrix Converter Applications", IEEE TRANSACTIONS ON POWER ELECTRONICS, INSTITUTE OF ELECTRICAL AND ELECTRONICS ENGINEERS, USA, Bd. 29, Nr. 5, 1. Mai 2014 (2014-05-01), Seiten 2563-2573, XP011536970, ISSN: 0885-8993, DOI: 10.1109/TPEL.2013.2290835 [gefunden am 2014-01-10]

EP 3 857 690 B1

**Beschreibung**

Die Erfindung betrifft ein Verfahren zur Erkennung eines Abschaltstromes durch einen elektronischen Schalter, wobei der elektronische Schalter zwei abschaltbare Halbleiterschalter aufweist. Ferner betrifft die Erfindung einen elektronischen Schalter mit zwei abschaltbaren Halbleiterschalter zur Durchführung des Verfahrens. Die Erfindung betrifft ferner ein Gleichspannungsnetz mit einem derartigen elektronischen Schalter.

Die Versorgung mit elektrischer Energie findet heutzutage in erster Linie über Wechselspannungsnetze statt. Diese haben den Vorteil, dass sich unterschiedliche Spannungsebenen mit Hilfe von Transformatoren herstellen lassen. Bidirektionale Halbleiterschalter mit Überwachung der Collector-Emitter-Spannung zur Erkennung von Fehlerzuständen werden, z.B., in US 2013/063188 beschrieben.

Durch Halbleiter, die immer kostengünstiger am Markt verfügbar sind, lassen sich auch für Gleichspannungsnetze auf einfache Weise unterschiedliche Spannungsebenen erzeugen, so dass gerade auch die Energieversorgung über Gleichspannungsnetze, insbesondere innerhalb von Industrienetzen, besonders wirtschaftlich wird.

Dazu zählen intelligente Leistungsmodule mit Sense-IGBTs, die einen Hilfsemitter zur Strommessung und eine VCE-Überwachungsschaltung zur Messung der Collector-Emitter-Spannung aufweisen, wie z.B. in US2013063188 beschrieben.

DC-Netze sollen dabei in zukünftigen Industrieanlagen Verluste reduzieren, den direkten Energieaustausch zwischen Umrichtern, Speichern und Motoren gewährleisten und eine erhöhte Robustheit erzielen. Dabei können beispielsweise kleine Gleichspannungsnetze, auch als Gleichspannungsnetze bezeichnet, mit unterschiedlichen Kabellängen zwischen den verschiedenen Lastabgängen und Einspeisungen betrieben werden. Gleichstromnetze können, im Vergleich zu Wechselstromnetzen, dabei eine deutlich größere Varianz in der Zuleitungsinduktivität und damit in dem Stromanstieg im Kurzschlussfall aufweisen, da hier einerseits keine Kurzschlussimpedanz eines vorgelagerten Transformators kurzschlussstrombegrenzend wirkt, sondern Energiespeicher in Form von kapazitiven Spannungszwischenkreisen als ideale Spannungsquellen sehr große Stromanstiege im Kurzschlussfall erzeugen können. Andererseits stellen sehr lange Zuleitungen nicht das Problem der zunehmenden Blindleistung durch Zunahme des Blindwiderstandes dar und somit sind große Reiheninduktivitäten durchaus zulässig, welche nur sehr kleine Stromanstiege im Kurzschluss zulassen, allerdings große Überspannungen beim Schalten verursachen.

Der Erfindung liegt die Aufgabe zugrunde, eine zuverlässige Überstromerkennung für einen elektronischen Schalter zu realisieren.

Diese Aufgabe wird durch ein Verfahren nach Anspruch 1 zur Erkennung eines Abschaltstromes durch einen elektronischen Schalter für ein Gleichspannungsnetz gelöst, wobei der elektronische Schalter zwei abschaltbare Halbleiterschalter aufweist, wobei die zwei abschaltbaren Halbleiterschalter derart angeordnet sind, dass sie jeweils einen Strom mit unterschiedlicher Polarität durch den elektronischen Schalter abschalten können, wobei die zwei abschaltbaren Halbleiterschalter entweder antiseriell, im Fall von rückwärts leitfähigen Halbleiterschaltern, oder antiparallel, im Fall von rückwärts sperrenden Halbleiterschaltern, im elektronischen Schalter angeordnet sind, wobei ein erster der abschaltbaren Halbleiterschalter mindestens vier Anschlüsse aufweist, wobei ein zweiter der abschaltbaren Halbleiterschalter mindestens drei Anschlüsse aufweist, wobei an dem ersten der zwei abschaltbaren Halbleiterschalter eine erste Spannung zwischen einem Emitter-Anschluss und einem Hilfsemitter-Anschluss und an einem zweiten der zwei abschaltbaren Halbleiterschalter eine zweite Spannung zwischen einem Kollektor-Anschluss und einem Emitter-Anschluss oder zwischen einem Drain-Anschluss und einem Source-Anschluss gemessen wird, wobei die gemessene Spannung oder das zeitliche Integral der gemessenen Spannung jeweils mit einem Referenzwert verglichen wird und bei Überschreiten des Referenzwertes der betreffende Halbleiterschalter abgeschaltet wird.

Ferner wird diese Aufgabe nach Anspruch 7 durch einen elektronischen Schalter für ein Gleichspannungsnetz aufweisend zwei abschaltbare Halbleiterschalter gelöst, wobei die zwei abschaltbaren Halbleiterschalter derart angeordnet sind, dass sie jeweils einen Strom mit unterschiedlicher Polarität durch den elektronischen Schalter abschalten können, wobei die zwei abschaltbaren Halbleiterschalter entweder antiseriell, im Fall von rückwärts leitfähigen Halbleiterschaltern, oder antiparallel, im Fall von rückwärts sperrenden Halbleiterschaltern, im elektronischen Schalter angeordnet sind, wobei ein erster der abschaltbaren Halbleiterschalter mindestens vier Anschlüsse aufweist, wobei ein zweiter der abschaltbaren Halbleiterschalter mindestens drei Anschlüsse aufweist, wobei der elektronische Schalter eine Spannungserfassung zur Messung einer ersten Spannung zwischen einem Emitter-Anschluss und einem Hilfsemitter-Anschluss an dem ersten der zwei abschaltbaren Halbleiterschalter und einer zweiten Spannung zwischen einem Kollektor-Anschluss und einem Emitter-Anschluss oder zwischen einem Drain-Anschluss und einem Source-Anschluss an dem zweiten der zwei abschaltbaren Halbleiterschalter aufweist, wobei der elektronische Schalter eine Auswerteeinheit aufweist, die dazu eingerichtet ist die gemessene Spannung oder das zeitliche Integral der gemessenen Spannung jeweils mit einem Referenzwert zu vergleichen und bei Überschreiten des Referenzwertes den betreffenden abschaltbaren Halbleiterschalter abzuschalten.

Diese Aufgabe wird weiter durch ein Gleichspannungsnetz nach Anspruch 8 mit einem derartigen elektronischen Schalter gelöst.

Weitere vorteilhafte Ausgestaltungen der Erfindung sind in den abhängigen Ansprüchen angegeben.

Der Erfindung liegt die Erkenntnis zugrunde, dass derzeitige Stromwandler zur Messung des Stroms durch einen elektronischen Schalter, der sich in einem DC-Netz befindet, nur bedingt geeignet sind. Bekannte Arten von Gleichstromsensoren, wie beispielsweise Halleffekt- oder magnetoresistive Sensoren haben eine relativ geringe Grenzfrequenz, typischerweise im Bereich von 400kHz und Totzeiten im Bereich von 500ns bis 1500ns. Bei sehr niederinduktivem Netzen können in dieser Zeitspanne der Strom im Fehlerfall, wie beispielsweise einem Kurzschluss, sehr schnell hohe Werte erreichen, welche zur Zerstörung oder Fehlfunktion des Halbleiters führen können.

So kann in einem Beispiel bei einer Gleichspannung des Gleichspannungsnetzes von 800V und einer angenommenen Zuleitung von 2m Länge, die einer Induktivität von etwa $1\mu H$ entspricht, ein Stromanstieg von

$$i(t) = (U/L) * \Delta t = (800V/1\mu H) * 1,5\mu s = 1200A$$

entstehen. Somit sind die bekannten Stromwandler nur bedingt geeignet, einen zuverlässigen Schutz des elektronischen Schalters und der in dem Abgang des elektronischen Schalters angeordneten Komponenten in einem Gleichspannungsnetz sicherzustellen.

Es hat sich aber gezeigt, dass für den Schutz und damit für das Auslösen, d.h. Öffnen, des elektronischen Schalters, vielmehr ein schnelles Ansprechen der Stromdetektion wichtig ist als eine hohe Genauigkeit. Es hat sich darüber hinaus gezeigt, dass durch das Messen von Spannungen am abschaltbaren Halbleiterschalter sehr schnell ein unzulässig hoher Strom erkannt werden kann, der vom elektronischen Schalter abzuschalten ist.

Es hat sich darüber hinaus gezeigt, dass man durch das Messen von Spannungen an den Anschlüssen des abschaltbaren Halbleiters einen hohen Strom bzw. einen hohen Stromanstieg zuverlässig erkennen kann.

Der abschaltbare Halbleiterschalter hat mindestens drei Anschlüsse. Bei Halbleitern auf der Basis von Transistoren wie IGBTs werden diese Anschlüsse als Gate (G) oder Basis, Kollektor (C) und Emitter (E) bezeichnet, bei einem MOSFET als Gate, Drain und Source. Dies erfindungsgemäße Verfahren funktioniert sowohl für abschaltbare Halbleiter mit Gate (G), Kollektor (C) und Emitter (E) als auch mit Gate, Drain und Source, wobei als Gate Anschluss auch ein vorhandener Basis Anschluss genutzt werden kann. Dabei entspricht der Gate Anschluss des IGBT dem Gate Anschluss des MOSFETs oder einem Basis Anschluss eines Transistors, der Kollektor Anschluss dem Drain Anschluss und der Emitter Anschluss dem Source Anschluss. Im Folgenden wird nicht mehr auf die Anschlüsse Gate, Drain und Source eingegangen. Jedoch sind die Ausführungen bezüglich Gate (G) bzw. Basis, Kollektor (C) und Emitter (E) in Bezug auf die Überstromerkennung ohne weiteres für sämtliche Ausführungsbeispiele auf die Anschlüsse Gate, Drain und Source übertragbar. Gleiches gilt für den später eingeführten Anschluss des Hilfsemitters.

Es hat sich gezeigt, dass sich hohe Ströme bzw. große Anstiegsgeschwindigkeiten von Strömen durch die Spannungen zwischen zwei der Anschlüsse des abschaltbaren Halbleiterschalters zuverlässig erkennen lassen. Übersteigt der gemessene Wert oder das Integral des gemessenen Wertes einen Referenzwert, auch als Grenzwert bezeichnet, so geht der abschaltbare Halbleiterschalter in den nichtleitenden Zustand über und der elektronische Schalter ist geöffnet. Der Referenzwert bzw. Grenzwert kann dabei vorgegeben und in der Auswerteeinheit abgelegt werden. Mittels der Auswerteeinheit wird der Messwert der Spannung bzw. sein Integral mit dem Referenzwert verglichen.

Während mit einer Messung der Spannung zwischen Kollektor und Emitter ein Strom durch den Halbleiter erkennbar ist, ist mit einer Messung zwischen dem Emitter und einem Hilfsemitter als vierter Anschluss des abschaltbaren Halbleiterschalters der Stromanstieg durch den abschaltbaren Halbleiter messbar. Dieser kann bereits für den Schutz durch Vergleich mit dem Referenzwert herangezogen werden, da anhand eines großen Stromanstiegs bereits ein Kurzschluss zuverlässig erkannt wird. Will man hingegen anstelle des Stromanstiegs das Abschalten des elektronischen Schalters bei Messung der Spannung zwischen Emitter und Hilfsemitter abhängig von der Stromhöhe gestalten, so ist anstelle des Spannungsmesswertes das zeitliche Integral über der gemessenen Spannung mit dem Referenzwert zu vergleich. Die Bildung des zeitlichen Integrals ist problemlos durch die Auswerteeinheit des elektronischen Schalters durchführbar.

Unter Abschalten eines abschaltbaren Halbleiterschalters wird verstanden, dass der abschaltbare Halbleiterschalter in den nichtleitenden Zustand versetzt wird.

Falls mehr als nur eine Spannung gemessen wird und/oder eine Spannung gemessen wird und sowohl der Wert der Messung als auch das zeitliche Integral für die Bestimmung des Abschaltkriteriums verwendet wird, können sich die Referenzwerte für den jeweiligen Vergleich unterscheiden.

Bei den beiden Halbleiterschaltern wird zwischen einem ersten und einem zweiten der beiden Halbleiterschalter unterschieden.

Bei dem zweiten Halbleiterschalter wird die Spannung zwischen einem Kollektor-Anschluss und einem Emitter-Anschluss bzw. zwischen einem Drain-Anschluss und einem Source-Anschluss des mindestens einen abschaltbaren Halbleiterschalters gemessen. Hier wird die Kollektor-Emitter-Spannung ($U_{CE}$) bzw. die Drain-Source-Spannung ($U_{DS}$) im eingeschalteten Zustand des abschaltbaren Halbleiters gemessen. Bei einem hohen Strom durch den abschaltbareren Halbleiterschalter baut sich zwischen dem Kollektor- und dem Emitteranschluss eine Spannung auf. Wird diese größer als ein Referenzwert, auch als Grenzwert bezeichnet, wird dieser als Überstrom erkannt und der abschaltbare Halbleiterschalter abgeschaltet. Befindet sich der abschaltbare Halbleiterschalter bei Erreichen dieses Referenzwertes bereits in Sättigung, so ist der Überstrom besonders einfach zu erkennen, da die Spannung in diesem Bereich deutlich mit der Stromstärke ansteigt. Allerdings hat sich auch gezeigt, dass bereits vor der Sättigung die Spannung zwischen Kollektor und Emitter bereits mit dem Strom durch den Halbleiter ansteigt. Die messtechnische Erkennung einer solchen Spannungsänderung ist zwar schwieriger als im gesättigten Bereich, aber auf jeden Fall noch messtechnisch ermittelbar. Anhand der Kollektor-Emitter Spannung lässt sich auf einfache Weise und vor allem hinreichend schnell ein hoher Strom durch den abschaltbaren Halbleiterschalter erkennen und mit dem Abschalten des abschaltbaren Halbleiterschalters reagieren. Dieser hohe Strom kann beispielsweise seine Ursache in einem Kurzschluss haben, der aufgrund der geringen Induktivitäten im Gleichspannungsnetz schnell einen hohen Strom verursacht. Durch die schnelle Überstromerkennung durch das Messen der Kollektor-Emitter-Spannung kann der Überstrom und Vergleichen mit einem Referenzwert kann der Überstrom zuverlässig und schnell erkannt werden. Dadurch lassen sich die Vorteile des elektronischen Schalters, insbesondere seine schnelle Schaltzeit im Bereich von 100ns besonders vorteilhaft nutzen.

Besonders gut ist die Stromabbildung über die Spannung, wenn der abschaltbare Halbleiterschalter sich in Sättigung befindet. Daher eignet sich diese Ausführungsform insbesondere für Abschaltströme, die sich nahe an der Belastungsgrenze des abschaltbaren Halbleiters befinden.

Dabei weist der erste der abschaltbaren Halbleiterschalter mindestens vier Anschlüsse auf, wobei die Spannung zwischen dem Emitter-Anschluss und einem Hilfsemitter-Anschluss des mindestens einen abschaltbaren Halbleiterschalters gemessen wird. Hierbei weist der abschaltbare Halbleiterschalter als zusätzlichen Anschluss, d.h. als vierten Anschluss, einen Hilfsemitter, bzw. eine Hilfssource auf. Hierbei wird die Spannung zwischen dem Emitter bzw. Source, auch als Hauptemitter bezeichnet, und dem Hilfsemitter gemessen. Fließt nun ein Strom mit einem sehr starken Anstieg durch die Kollektor-Emitter Strecke des abschaltbaren Halbleiterschalters, so fällt eine Spannung über eine Zuleitungsinduktivität $L_E$ im Innern des Halbleiters ab, welche proportional zum Stromanstieg ist. Integriert man diese gemessene Spannung, was digitaltechnisch sehr einfach realisierbar ist, erhält man einen Wert proportional zum Strom durch den abschaltbaren Halbleiterschalter. Ist darüber hinaus außerdem den Wert der Zuleitungsinduktivität $L_E$ bekannt, ist sogar der genaue Wert des Stromes berechenbar. Dieser ist aber nicht zwingend notwendig, man benötigt lediglich einen Referenzwert, welcher bei Überschreitung den Überstrom zuverlässig erkennt. Auch diese Methode kommt ohne Stromwandler aus und ist besonders schnell, so dass schnell ansteigende Ströme sicher und zuverlässig sowie besonders schnell erkannt werden können. Dadurch lassen sich auch durch diese Ausführungsform die Vorteile des elektronischen Schalters, insbesondere seine schnelle Schaltzeit im Bereich von 100ns, besonders vorteilhaft nutzen.

Darüber hinaus ist dieses Verfahren über die Messung der Spannung zwischen Emitter und Hilfsemitter auch dann mit einfachen Spannungssensoren durchführbar, wenn sich der Halbleiter noch nicht in Sättigung befindet. Damit eignet sich dieses Verfahren im Besonderen für Abschaltströme, die deutlich Unterhalb der Belastungsgrenze des abschaltbaren Halbleiterschalters liegen.

Weiterhin hat es sich als vorteilhaft erwiesen, auch eine klassische Strommessung über einen Stromsensor durchzuführen, da man so langsam ansteigende Stromanstiege detektieren kann. Diese Strommessung kann dann in Kombination mit der Erkennung über gemessene Spannungen zwischen Kollektor und Emitter und über eine Messung zwischen Emitter und Hilfsemitter ein besonders sicherer Kurzschlussschutz für einen elektronischen Schalter über einen weiten Bereich an Reiheninduktivität, auch als Zuleitungsinduktivitäten bezeichnet, und Überstromszenarien realisiert werden. Dabei wird an dem abschaltbaren Halbleiter sowohl die Spannung zwischen Kollektor und Emitter als auch die Spannung zwischen Emitter und Hilfsemitter gemessen. Damit ergibt sich zusammen mit der relativ langsamen Messung über den Stromsensor ein dreistufiges Schutzkonzept zur Herstellung der Betriebssicherheit des elektronischen Schalters in allen bekannten Überstromfällen. Die Referenzwerte für den Vergleich mit den gemessenen Spannungen bzw. deren zeitlichen Integral können sich dabei für jede Messung unterscheiden.

Zusammenfassend wird die der Erfindung zugrundeliegende Aufgabe durch das Verfahren zur Erkennung eines Abschaltstromes durch einen elektronischen Schalter besonders vorteilhaft gelöst, dass der elektronische Schalter zwei abschaltbaren Halbleiterschalter aufweist, wobei die zwei abschaltbaren Halbleiterschalter derart angeordnet sind, dass sie jeweils einen Strom mit unterschiedlicher Polarität durch den elektronischen Schalter abschalten können, insbesondere wobei die zwei abschaltbaren Halbleiterschalter antiseriell im elektronischen Schalter angeordnet sind, wobei ein erster der abschaltbare Halbleiterschalter mindestens vier Anschlüsse aufweist, wobei ein zweiter der abschaltbaren Halbleiterschalter mindestens drei Anschlüsse aufweist, wobei an dem ersten der zwei abschaltbaren Halbleiterschalter eine erste Spannung zwischen einem Emitter-Anschluss und einem Hilfsemitter-Anschluss und an einem zweiten der zwei abschaltbaren Halbleiterschalter eine zweite Spannung zwischen einem Kollektor-Anschluss und einem Emitter-Anschluss oder zwischen einem Drain-Anschluss und einem Source-Anschluss gemessen wird, wobei die gemessene Spannung oder das zeitliche Integral der gemessenen Spannung jeweils mit einem Referenzwert verglichen wird und bei Überschreiten des Referenzwertes mindestens einer der zwei abschaltbaren Halbleiterschalter abgeschaltet wird. Ferner wird die Aufgabe durch einen elektronischen Schalter aufweisend zwei abschaltbare Halbleiterschalter gelöst, wobei die zwei abschaltbaren Halbleiterschalter derart angeordnet sind, dass sie jeweils einen Strom mit unterschiedlicher Polarität durch den elektronischen Schalter abschalten können, insbesondere wobei die zwei abschaltbaren Halbleiterschalter antiseriell im elektronischen Schalter angeordnet sind, wobei ein erster der abschaltbare Halbleiterschalter mindestens vier Anschlüsse aufweist, wobei ein zweiter der abschaltbaren Halbleiterschalter mindestens drei Anschlüsse aufweist, wobei der elektronische Schalter eine Spannungserfassung zur Messung einer ersten Spannung zwischen einem Emitter-Anschluss und einem Hilfsemitter-Anschluss an dem ersten der zwei abschaltbaren Halbleiterschalter und einer zweiten Spannung zwischen einem Kollektor-Anschluss und einem Emitter-Anschluss oder zwischen einem Drain-Anschluss und einem Source-Anschluss an dem zweiten der zwei abschaltbaren Halbleiterschalter aufweist, wobei der elektronische Schalter eine der Auswerteeinheit aufweist, die dazu eingerichtet ist die gemessene Spannung oder das zeitliche Integral der gemessenen Spannung jeweils mit einem Referenzwert zu vergleichen und bei Überschreiten des Referenzwertes mindestens einen der zwei abschaltbaren Halbleiterschalter abzuschalten.

Bei einer vorteilhaften Ausgestaltung der Erfindung weist der elektronische Schalter zwei abschaltbaren Halbleiterschalter auf, wobei an den zwei abschaltbaren Halbleiterschalter jeweils die Spannung zwischen zwei Anschlüssen gemessen wird, wobei bei Überschreiten des Referenzwertes der betreffende abschaltbare Halbleiterschalter abgeschaltet wird. Die zwei abschaltbaren Halbleiterschalter sind dabei so angeordnet, dass sie jeweils einen Strom mit unterschiedlicher Polarität durch den Schalter abschalten können. Wenn es sich bei den abschaltbaren Halbleiterschaltern um rückwärts sperrende Halbleiterschalter handelt, werden diese in einer Parallelschaltung angeordnet, bei der für jede Stromrichtung jeweils einer der beiden abschaltbaren Halbleiterschalter den Strom führen und abschalten kann. Diese Parallelschaltung wird auch als Antiparallelschaltung oder die Anordnung als antiparallel bezeichnet. Für den Fall, dass die abschaltbaren Halbleiterschalter rückwärts leitfähig sind, erkennbar im Schaltbild an einer Diode, die antiparallel zum schaltenden Element angeordnet ist, so werden die beiden abschaltbaren Halbleiterschalter in einer Reihenschaltung angeordnet, bei dem in einer Stromrichtung der Strom durch das schaltende Element des ersten der beiden abschaltbaren Halbleiterschalter fließt und durch die Diode des zweiten der beiden abschaltbaren Halbleiterschalter. Bei entgegengesetzter Stromrichtung, d.h. bei entgegengesetzter Polarität des Stromes fließt der Strom durch das schaltende Element des zweiten der beiden abschaltbaren Halbleiterschalter und durch die Diode des ersten der beiden abschaltbaren Halbleiterschalter. Diese Anordnung wird auch als antiseriell bezeichnet. An beiden der abschaltbaren Halbleiterschalter kann dann an zwei der Anschlüsse die Spannung gemessen werden. Dies kann an den jeweils gleichen Anschlüssen oder auch an unterschiedlichen Anschlüssen geschehen. Ebenfalls kann der Referenzwert, d.h. der Grenzwert, mit der die gemessene Spannung verglichen wird, identisch sein oder sich unterscheiden. Dabei kann nach überschreiten des Referenzwert nur der betroffene abschaltbare Halbleiterschalter abgeschaltet werden oder es werden beide abschaltbaren Halbleiterschalter abgeschaltet.

Mit unterschiedlichen Referenzwerten kann damit auf einfache Weise ein richtungsabhängiger Schutz realisiert werden. Dabei ist der zulässige Strom in eine Richtung durch den elektronischen Schalter größer als in der anderen Richtung. Dann wird auch nur der abschaltbare Halbleiterschalter abgeschaltet, an dem der Referenzwert überschritten wird. Somit kann beispielsweise ein Kurzschlussschutz für die Lasten, die über den elektronischen Schalter mit der DC Quelle verbunden sind einen niedrigeren Grenzwert haben für den Strom von der Quelle zur Last, während bei umgekehrter Stromrichtung, also von der Last zur DC Quelle ein höherer Referenzwert vorgesehen wird, damit ein an anderer Stelle im Gleichspannungsnetz auftretender Kurzschluss nicht den elektronische Schalter ausschaltet, in Abgängen, in denen gar kein Kurzschluss vorhanden ist. Mit dieser Selektivität kann erreicht werden, dass schnell nur der von einem Kurzschluss betroffene Abgang abgeschaltet, während die elektronischen Schalter der übrigen Abgänge eingeschaltet bleiben, um die intakten Teile des Gleichspannungsnetzes weiter betriebsfähig zu halten auch wenn in diesen Teilen aufgrund des Kurzschlusses im anderen Abgang kurzzeitig ein höherer Strom fließt. Somit kann auf einfache Weise der Betrieb von nicht gestörten Teilen des Gleichspannungsnetzes weiter sichergestellt werden.

Besonders vorteilhaft ist, wie oben bereits dargestellt, der dreistufige Schutz für jeden der beiden abschaltbaren Halbleiterschalter. Dazu wird neben dem Stromsensor an beiden Halbleiterschaltern jeweils die Spannung zwischen Kollektor und Emitter sowie die Spannung Emitter und Hilfsemitter gemessen und mit jeweiligen Referenzwerten vergleichen. Dies bietet einen guten Schutz für alle erdenklichen Fehlerfälle im Gleichspannungsnetz.

Erfindungsgemäß weist ein erster der abschaltbaren Halbleiterschalter mindestens vier Anschlüsse auf, wobei an dem ersten der zwei abschaltbaren Halbleiterschalter die Spannung zwischen einem Emitter-Anschluss und einem Hilfsemitter-Anschluss und an einem zweiten der zwei abschaltbaren Halbleiterschalter die Spannung zwischen einem Kollektor-Anschluss und einem Emitter-Anschluss gemessen wird. Dabei hat es sich als vorteilhaft erwiesen, wenn die Spannungserfassung zur Messung der Spannung zwischen einem Emitter-Anschluss und einem Hilfsemitter-Anschluss eines ersten der zwei abschaltbaren Halbleiterschalter und zur Messung der Spannung zwischen einem Kollektor-Anschluss und einem Emitter-Anschluss eines zweiten der zwei abschaltbaren Halbleiterschalter ausgelegt ist. Mit dieser Anordnung ist ein selektiver Schutz auf besonders einfache Weise möglich. Für den Abschaltstrom von der DC Quelle zur Last wird für den abschaltbaren Halbleiterschalter, der diesen Strom führen und abschalten kann ein geringerer Referenzwert, d.h. Grenzwert, vorgesehen. Dies geschieht über die Spannungsmessung an Emitter und Hilfsemitter. Diese ist in diesem Bereich des Abschaltstromes besonders günstig. Ebenfalls kann ein Auslösen hier bereits nicht bei Erreichen eines Stromwertes, sondern aufgrund der hohen Stromsteilheit, die typisch ist für einen Kurzschluss, vorgenommen werden. Die Auslösung aufgrund der hohen Steilheit erfolgt durch Vergleich der gemessenen Spannung mit dem Referenzwert. Die Auslösung aufgrund der Stromhöhe erfolgt durch Vergleich des zeitlichen Integrals der gemessenen Spannung mit dem Referenzwert.

Für die entgegengesetzte Polarität wird an dem zweiten abschaltbaren Halbleiterschalter, der diesen Strom führen und abschalten kann die Spannung an Kollektor und Emitter gemessen. Aufgrund des höheren Abschaltstromes geht der abschaltbare Halbleiter dann bereits in Sättigung, so dass diese Messung ebenfalls mit hoher Genauigkeit durchgeführt werden kann. Für diese Richtung ist auch die Änderung des Stromes nicht von Bedeutung, so dass auf die Messung zwischen Emitter und Hilfsemitter verzichtet werden kann.

Bei einer weiteren vorteilhaften Ausgestaltung der Erfindung wird bei Überschreiten des Referenzwertes der betreffende abschaltbare Halbleiterschalter abgeschaltet. Somit kann der Schutz richtungsselektiv durchgeführt werden. Beispielsweise kann nur die Aufnahme von elektrischer Energie aus einer DC Quelle unterbrochen werden, während ein Rückspeisen von Energie in ein Gleichspannungsnetz weiterhin möglich ist, sofern dieser Grenzwert nicht überschritten wird.

Bei einer weiteren vorteilhaften Ausgestaltung der Erfindung wird für einen selektiven Schutz die erste gemessene Spannung oder das Integral der ersten gemessene Spannung mit einem ersten Referenzwert verglichen und die zweite gemessene Spannung mit einem zweiten Referenzwert verglichen, wobei bei Überschreiten des jeweiligen Referenzwertes der betreffende abschaltbare Halbleiterschalter abgeschaltet wird oder beide Halbleiterschalter abgeschaltet werden. Damit kann für eine erste Richtung des Stromes ein erster Grenzwert und für die entgegengesetzte Stromrichtung ein zweiter Grenzwert vorgegeben werden. Bei dem Grenzwert kann es sich um einen Grenzwert für den Stromanstieg und/oder einen Strom handeln. Sofern die gemessene Spannung und das Integral der gemessenen Spannung ausgewertet werden, kann der Referenzwert einen Grenzwert für eine Strom und einen Grenzwert für eine Stromanstiegsgeschwindigkeit umfassen. Bei diesem Ausführungsbeispiel kann der Schutz nicht nur richtungsselektiv erfolgen, sondern es kann auch für jede Stromrichtung ein eigener Grenzwert vorgegeben werden. Dabei kann im besonderen Maße der Schalter an die vorhandenen Netzverhältnisse oder an die angeschlossenen Lasten bzw. elektrischen Verbraucher angepasst werden.

Bei einer weiteren vorteilhaften Ausgestaltung der Erfindung wird für einen selektiven Schutz das Integral der ersten gemessene Spannung mit einem ersten Referenzwert verglichen, wobei der erste Referenzwert kleiner ist als der zweite Referenzwert. Dabei kann beiden Referenzwerten eindeutig ein Strom zugeordnet werden. In diesem Fall sind die beiden Referenzwerte miteinander vergleichbar und es kann der erste Referenzwert kleiner gewählt werden als der zweite Referenzwert, da über die erste gemessene Spannung kleiner Stromwerte besser erkannt werden können als über die zweite gemessene Spannung.

Bei einer weiteren vorteilhaften Ausgestaltung der Erfindung an dem ersten Halbleiterschalte zusätzlich eine dritte Spannung zwischen dem Kollektor-Anschluss und dem Emitter-Anschluss gemessen wird und bei Überschreiten eines dritten Grenzwertes der erste Halbleiterschalter abgeschaltet wird. Durch die zusätzliche Messung der dritten Spannung kann der Schutz durch den elektronischen Schalter besonders sicher und zuverlässig realisiert werden, da er mehrstufig ausgeführt ist.

Bei einer weiteren vorteilhaften Ausgestaltung der Erfindung ist der elektronische Schalter derart zwischen einer DC Quell und einer Last angeordnet, dass ein Strom von der DC Quelle zu der Last mittels des ersten Halbleiterschalters abschaltbar ist und ein Strom von der Last zu der DC Quelle mittels des zweiten Halbleiterschalters abschaltbar ist. Bei dieser Ausgestaltung lassen sich die Vorteile des elektronischen Schalters besonders gut nutzen. Ein Strom von der DC Quelle zur Last kann zuverlässig und schnell abgeschaltet werden, insbesondere dann, wenn es sich um einen Kurzschlussstrom handelt, der von der betreffenden Last, die durch den elektronischen Schalter abgesichert werden soll, verursacht wird. Kurzschlüsse in anderen Lastabgängen, die einen Stromfluss von der Last in Richtung der DC Quelle verursachen, würden dann nicht zu einem Öffnen des elektronischen Schalters führen, da die Werte entsprechend eingestellt sind, dass der Kurzschluss von dem betreffenden Schalter im zugehörigen Lastabgang erkannt und unterbrochen wird. Die störungsfreien Lasten können dann problemlos und zuverlässig im Gleichspannungsnetz weiter in Betrieb bleiben.

Dies kann insbesondere bei einer Ausgestaltung realisiert werden, bei der die Auswerteeinheit dafür eingerichtet ist, für einen selektiven Schutz das Integral der ersten gemessene Spannung mit einem ersten Referenzwert zu vergleichen und die zweite gemessene Spannung mit einem zweiten Referenzwert zu vergleichen und bei Überschreiten des jeweiligen Referenzwertes den betreffenden abschaltbaren Halbleiterschalter abzuschalten, wobei der erste Referenzwert kleiner ist als der zweite Referenzwert.

Im Folgenden wird die Erfindung anhand der in den Figuren dargestellten Ausführungsbeispielen näher beschrieben und erläutert. Es zeigen:

FIG 1 ein Gleichspannungsnetz mit einem elektronischen Schalter,
FIG 2 ein abschaltbaren Halbleiterschalter und

FIG 3    ein Ablaufdiagramm des Verfahrens zur Erkennung eines Abschaltstromes.

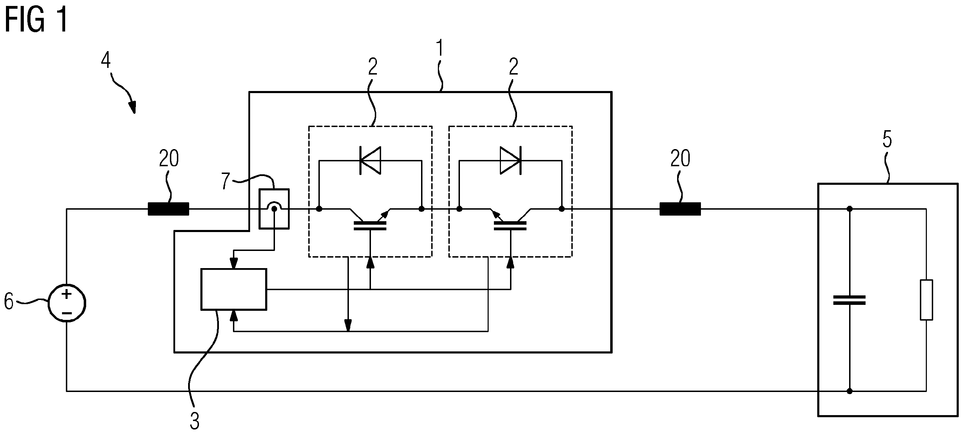

Die FIG 1 zeigt ein Gleichspannungsnetz 4 mit einer DC Quelle 6, die über einen elektronischen Schalter 1 eine Last 5 speist. Die einzelnen Leitungen in dem Gleichspannungsnetz weisen dabei eine Reiheninduktivität 20 auf, die zum einen die Anstiegsgeschwindigkeit des Stromes im Fehlerfall, wie beispielsweise einem Kurzschluss, begrenzen. Der elektronische Schalter 1 weist in diesem Ausführungsbeispiel zwei abschaltbare Halbleiterschalter 2 auf, die, weil rückwärts leitfähig, antiseriell angeordnet sind. Die beiden abschaltbaren Halbleiterschalter 2 werden von einer Auswerteeinheit 3 angesteuert. Diese kann die einzelnen abschaltbaren Halbleiterschalter 2 einschalten, d.h. den Halbleiter in den leitfähigen Zustand versetzen, oder abschalten, d.h. in den sperrenden Zustand versetzen. Um einen Überstrom zu erkennen verwendet die Auswerteeinheit Messwerte von zwei der Anschlüsse des jeweiligen abschaltbaren Halbleiterschalters 2. Zusätzlich kann, nicht notwendigerweise, auch noch das Signal eines Stromsensors 7 ausgewertet werden. Dieser Stromsensor 7 kann sich innerhalb des elektronischen Schalters 1 oder außerhalb befinden.

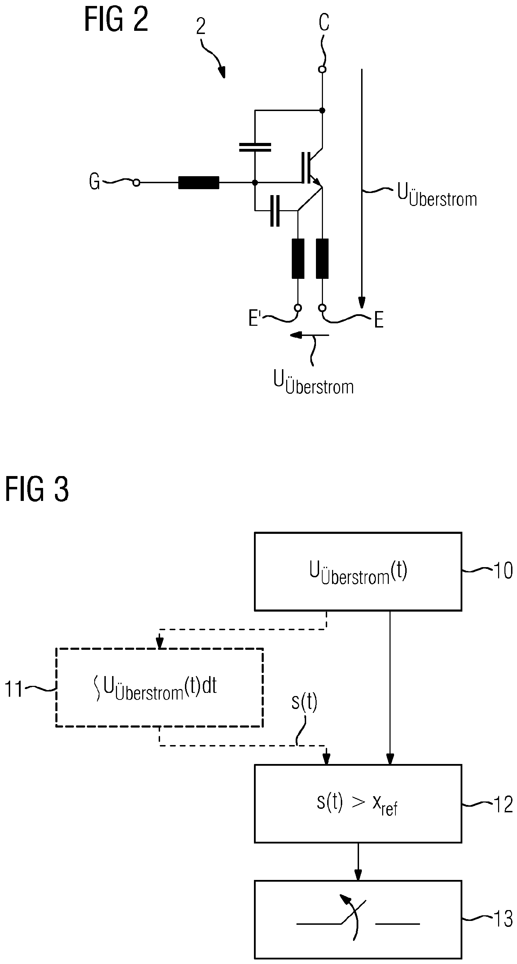

Die FIG 2 zeigt einen abschaltbaren Halbleiterschalter 2 mit seinen Anschlüssen Gate G, Kollektor C und Emitter E. Je nach verwendetem Verfahren zur Überstromerkennung wird auch noch ein vierter Anschluss, der Hilfsemitter E', benötigt. Der Strom durch den elektronischen Schalter 1 fließt vom Kollektor C zum Emitter E. Der Hilfsemitter E' dient nur zum Messen der Spannung zwischen Emitter E und Hilfsemitter E', wird jedoch nicht zum Führen des Stromes durch den abschaltbaren Halbleiterschalter 2 verwendet. Zur Erkennung eines Überstroms kann nun die Spannung $U_{Überstrom}$ zwischen Kollektor C und Emitter E gemessen werden. Alternativ ist es möglich, auch die Spannung $U_{Überstrom}$ zwischen dem Emitter E und dem Hilfsemitter E' zu messen. Auch die Kombination, d.h. die Messung beider Spannungen kann durchgeführt werden, um den Schutz redundant zu gestalten und auf unterschiedliche Fehlerfälle besser reagieren zu können.

Die FIG 3 zeigt den Ablauf des Verfahrens zur Erkennung eines Überstroms. Dabei wird in einem ersten Schritt 10 die Spannung $U_{Überstrom}$ zwischen zwei der Anschlüsse C, E, E' des abschaltbaren Halbleiterschalters 2 gemessen. Dieses Signal s(t) wird dann direkt zum Vergleich 12 mit einem Referenzwert $X_{ref}$ verwendet. Alternativ oder ergänzend kann der Wert der gemessenen Spannung $U_{Überstrom}$, gestrichelt dargestellt, auch über die Zeit integriert werden. D.h., es wird das zeitliche Integral über die gemessene Spannung $U_{Überstrom}$ gebildet. Auch dieses Signal s(t) wird dann dem Vergleich 12 mit einem Referenzwert $X_{ref}$ zugeführt. Dabei können aus der Messung der Spannung $U_{Überstrom}$ der Messwert an sich und/oder das zeitliche Integral der Spannung $U_{Überstrom}$ dem Vergleich 12 mit dem Referenzwert $X_{ref}$ zugeführt werden. Stellt sich bei dem Vergleich 12 heraus, dass das Signal s(t) größer ist als der zugehörige Referenzwert $X_{ref}$, so wird der betreffende abschaltbare Halbleiterschalter, an dem die Spannung $U_{Überstrom}$ gemessen wurde, oder beide Halbleiterschalter abgeschaltet 13, d.h. in den sperrenden Zustand versetzt. Angedeutet ist dies über das Symbol eines sich öffnenden mechanischen Schalters.

Dieses Verfahren wird für die beiden antiseriell angeordneten Halbleiterschalter 2 des elektronischen Schalters 1 durchgeführt.

Diese Überwachung findet kontinuierlich statt, vorzugsweise in der oben beschriebenen Auswerteeinheit 3.

Zusammenfassend betrifft die Erfindung ein Verfahren zur Erkennung eines Abschaltstromes durch einen elektronischen Schalter, wobei der elektronische Schalter mindestens einen abschaltbaren Halbleiterschalter aufweist, wobei der abschaltbare Halbleiterschalte mindestens drei Anschlüsse aufweist. Zur zuverlässigen Erkennung eines Überstroms für den elektronischen Schalter wird vorgeschlagen, dass eine Spannung zwischen zwei der mindestens drei Anschlüsse gemessen wird, wobei die Spannung oder das zeitliche Integral der Spannung mit einem Referenzwert verglichen wird und bei Überschreiten des Referenzwertes mindestens einer des mindestens einen abschaltbaren Halbleiterschalters abgeschaltet wird. Ferner betrifft die Erfindung einen elektronischer Schalter mit mindestens einem abschaltbaren Halbleiterschalter, wobei der abschaltbare Halbleiterschalter mindestens drei Anschlüsse aufweist, wobei der elektronische Schalter eine Spannungserfassung zur Messung einer Spannung zwischen zwei der mindestens drei Anschlüsse aufweist, wobei der elektronische Schalter eine Auswerteeinheit aufweist, wobei mittels der Auswerteeinheit die gemessene Spannung mit einem Referenzwert vergleichbar ist, wobei mittels der Auswerteeinheit bei Überschreiten des Referenzwertes der mindestens eine abschaltbare Halbleiterschalter abschaltbar ist. Die Erfindung betrifft weiter ein Gleichspannungsnetz mit einem derartigen elektronischen Schalter.

In Summe betrifft die Erfindung zusammenfassend ein Verfahren zur Erkennung eines Abschaltstromes durch einen elektronischen Schalter, wobei der elektronische Schalter zwei abschaltbaren Halbleiterschalter aufweist, wobei die zwei abschaltbaren Halbleiterschalter derart angeordnet sind, dass sie jeweils einen Strom mit unterschiedlicher Polarität durch den elektronischen Schalter abschalten können, insbesondere wobei die zwei abschaltbaren Halbleiterschalter antiseriell im elektronischen Schalter angeordnet sind, wobei ein erster der abschaltbare Halbleiterschalter mindestens vier Anschlüsse aufweist, wobei ein zweiter der abschaltbaren Halbleiterschalter mindestens drei Anschlüsse aufweist, wobei an dem ersten der zwei abschaltbaren Halbleiterschalter eine erste Spannung zwischen einem Emitter-Anschluss und einem Hilfsemitter-Anschluss und an einem zweiten der zwei abschaltbaren Halbleiterschalter eine zweite Spannung zwischen einem Kollektor-Anschluss und einem Emitter-Anschluss oder zwischen einem Drain-Anschluss und einem Source-Anschluss gemessen wird, wobei die gemessene Spannung oder das zeitliche Integral der gemessenen Spannung jeweils mit einem Referenzwert verglichen wird und bei Überschreiten des Referenzwertes mindestens einer der zwei abschaltbaren Halbleiterschalter abgeschaltet wird. Ferner betrifft die Erfindung einen elektronischen Schalter zur Durchführung eines derartigen Verfahrens.

Die Erfindung betrifft weiter ein Gleichspannungsnetz mit einem derartigen elektronischen Schalter.

## Patentansprüche

1. Verfahren zur Erkennung eines Abschaltstromes durch einen elektronischen Schalter (1) für ein Gleichspannungsnetz, wobei der elektronische Schalter (1) zwei abschaltbare Halbleiterschalter (2) aufweist, wobei die zwei abschaltbaren Halbleiterschalter (2) derart angeordnet sind, dass sie jeweils einen Strom mit unterschiedlicher Polarität durch den elektronischen Schalter (1) abschalten können, wobei die zwei abschaltbaren Halbleiterschalter (2) entweder antiseriell, im Fall von rückwärts leitfähigen Halbleiterschaltern, oder antiparallel, im Fall von rückwärts sperrenden Halbleiterschaltern, im elektronischen Schalter (1) angeordnet sind, wobei ein erster der abschaltbaren Halbleiterschalter (2) mindestens vier Anschlüsse (G,C,E,E') aufweist, wobei ein zweiter der abschaltbaren Halbleiterschalter (2) mindestens drei Anschlüsse (G,C,E) aufweist, wobei an dem ersten der zwei abschaltbaren Halbleiterschalter (2) eine erste Spannung ($U_{\text{Über-strom},1}$) zwischen einem Emitter-Anschluss (E) und einem Hilfsemitter-Anschluss (E') und an einem zweiten der zwei abschaltbaren Halbleiterschalter (2) eine zweite Spannung ($U_{\text{Überstrom},2}$) zwischen einem Kollektor-Anschluss (C) und einem Emitter-Anschluss (E) oder zwischen einem Drain-Anschluss und einem Source-Anschluss gemessen wird, wobei die gemessene Spannung ($U_{\text{Überstrom},1}$, $U_{\text{Überstrom},2}$) oder das zeitliche Integral der gemessenen Spannung ($U_{\text{Überstrom},1}$, $U_{\text{Überstrom},2}$) jeweils mit einem Referenzwert ($X_{\text{ref}}$) verglichen wird und bei Überschreiten des Referenzwertes ($X_{\text{ref}}$) der betreffende abschaltbare Halbleiterschalter (2) abgeschaltet wird.

2. Verfahren nach Anspruch 1, wobei mit unterschiedlichen Referenzwerten ein richtungsabhängiger Schutz realisiert werden kann.

3. Verfahren nach einem der Ansprüche 1 oder 2, wobei für einen selektiven Schutz die erste gemessene Spannung ($U_{\text{Über-strom},1}$) und/oder das Integral der ersten gemessenen Spannung ($U_{\text{Überstrom},1}$) mit einem ersten Referenzwert ($X_{\text{ref},1}$) verglichen wird und die zweite gemessene Spannung ($U_{\text{Überstrom},2}$) mit einem zweiten Referenzwert ($X_{\text{ref},2}$) verglichen wird, wobei bei Über-schreiten des jeweiligen Referenzwertes ($X_{\text{ref},1}$,$X_{\text{ref},2}$) der betreffende abschaltbare Halbleiterschalter (2) abgeschaltet wird oder beide Halbleiterschalter (2) abgeschaltet werden.

4. Verfahren nach Anspruch 3, wobei für einen selektiven Schutz das Integral der ersten gemessenen Spannung ($U_{\text{Überstrom},1}$) mit einem ersten Referenzwert ($X_{\text{ref},1}$) verglichen wird, wobei der erste Referenzwert ($X_{\text{ref},1}$) kleiner ist als der zweite Referenzwert ($X_{\text{ref},2}$).

5. Verfahren nach einem der Ansprüche 1 bis 4, wobei an dem ersten Halbleiterschalter (2) zusätzlich eine dritte Spannung ($U_{\text{Überstrom},3}$) zwischen dem Kollektor-Anschluss (C) und dem Emitter-Anschluss (E) gemessen wird und bei Überschreiten eines dritten Grenzwertes ($X_{\text{ref},3}$) der erste Halbleiterschalter (2) abgeschaltet wird.

6. Verfahren nach einem der Ansprüche 1 bis 5, wobei ein Stromsensor als Mittel zur Stromerfassung verwendet wird, wobei unabhängig von den gemessenen Spannungen ($U_{\text{Überstrom},1}$, $U_{\text{Überstrom},2}$, $U_{\text{Überstrom},3}$) einer der abschaltbaren Halbleiterschalter (2) oder die abschaltbaren Halbleiterschalter (2) geöffnet werden, wenn der durch den Stromsensor erfasste Wert einen Grenzwert überschreitet.

7. Elektronischer Schalter (1) für ein Gleichspannungsnetz aufweisend zwei abschaltbare Halbleiterschalter (2), wobei die zwei abschaltbaren Halbleiterschalter (2) derart angeordnet sind, dass sie jeweils einen Strom mit unterschiedlicher Polarität durch den elektronischen Schalter (1) abschalten können, wobei die zwei abschaltbaren Halbleiterschalter (2) entweder antiseriell, im Fall von rückwärts leitfähigen Halbleiterschaltern, oder antiparallel, im Fall von rückwärts sperrenden Halbleiterschaltern, im elektronischen Schalter (1) angeordnet sind, wobei ein erster der abschaltbaren Halbleiterschalter (2) mindestens vier Anschlüsse (G,C,E,E') aufweist, wobei ein zweiter der abschaltbaren Halbleiterschalter (2) mindestens drei Anschlüsse (G,C,E) aufweist, wobei der elektronische Schalter eine Spannungserfassung zur Messung einer ersten Spannung ($U_{\text{Überstrom},1}$) zwischen einem Emitter-Anschluss (E) und einem Hilfsemitter-Anschluss (E') an dem ersten der zwei abschaltbaren Halbleiterschalter (2) und einer zweiten Spannung ($U_{\text{Überstrom},2}$) zwischen einem Kollektor-Anschluss (C) und einem Emitter-Anschluss (E) oder zwischen einem Drain-Anschluss und einem Source-Anschluss an dem zweiten der zwei abschaltbaren Halbleiterschalter (2) aufweist, wobei der elektronische Schalter (1) eine Auswerteeinheit (3) aufweist, die dazu eingerichtet ist, die gemessene Spannung ($U_{\text{Überstrom},1}$, $U_{\text{Überstrom},2}$) oder das zeitliche Integral der gemessenen Spannung ($U_{\text{Überstrom},1}$, $U_{\text{Überstrom},2}$) jeweils mit einem Referenzwert ($X_{\text{ref}}$) zu vergleichen und bei Überschreiten des Referenzwertes ($X_{\text{ref}}$) den betreffenden abschaltbaren Halbleiterschalter (2) abzuschalten.

8. Gleichspannungsnetz (4) mit einem elektronischen Schalter (1) nach Anspruch 7.

9. Gleichspannungsnetz (4) nach Anspruch 8, wobei der elektronische Schalter (1) derart zwischen einer DC Quelle (6) und einer Last (5) angeordnet ist, dass ein Strom von der DC Quelle (6) zu der Last (5) mittels des ersten Halbleiterschalters (2) abschaltbar ist und ein Strom von der Last (5) zu der DC Quelle (6) mittels des zweiten Halbleiterschalters (2) abschaltbar ist.

10. Gleichspannungsnetz (4) nach einem der Ansprüche 8 oder 9, wobei die Auswerteeinheit (3) eingerichtet ist, für einen selektiven Schutz das Integral der ersten gemessenen Spannung ($U_{\text{Überstrom},1}$) mit einem ersten Referenzwert ($X_{\text{ref},1}$) zu vergleichen und die zweite gemessene Spannung ($U_{\text{Überstrom},2}$) mit einem zweiten Referenzwert ($X_{\text{ref},2}$) zu vergleichen und bei Überschreiten des jeweiligen Referenzwertes ($X_{\text{ref},1}$, $X_{\text{ref},2}$) den betreffenden abschaltbaren Halbleiterschalter (2) abzuschalten, wobei der erste Referenzwert ($X_{\text{ref},1}$) kleiner ist als der zweite Referenzwert ($X_{\text{ref},2}$).

**Claims**

1. Method for detecting a turn-off current through an electronic switch (1) for a DC voltage grid, wherein the electronic switch (1) comprises two turn-off semiconductor switches (2), wherein the two turn-off semiconductor switches (2) are arranged in such a way that they can each turn off a current having a different polarity through the electronic switch (1), wherein the two turn-off semiconductor switches (2) are arranged either in antiseries, in the case of reverse conducting semiconductor switches, or in antiparallel, in the case of reverse blocking semiconductor switches, in the electronic switch (1), wherein a first of the turn-off semiconductor switches (2) comprises at least four terminals (G, C, E, E'), wherein a second of the turn-off semiconductor switches (2) comprises at least three terminals (G, C, E), wherein at the first of the two turn-off semiconductor switches (2) a first voltage ($U_{\text{overcurrent},1}$) is measured between an emitter terminal (E) and an auxiliary emitter terminal (E') and at a second of the two turn-off semiconductor switches (2) a second voltage ($U_{\text{overcurrent},2}$) is measured between a collector terminal (C) and an emitter terminal (E) or between a drain terminal and a source terminal, wherein the measured voltage ($U_{\text{overcurrent},1}$, $U_{\text{overcurrent},2}$) or the time integral of the measured voltage ($U_{\text{overcurrent},1}$, $U_{\text{overcurrent},2}$) is compared in each case with a reference value ($X_{\text{ref}}$) and the relevant turn-off semiconductor switch (2) is turned off in the event of the reference value ($X_{\text{ref}}$) being exceeded.

2. Method according to Claim 1, wherein direction-dependent protection can be realized with different reference values.

3. Method according to either of Claims 1 and 2, wherein for selective protection the first measured voltage ($U_{\text{overcurrent},1}$) and/or the integral of the first measured voltage ($U_{\text{overcurrent},1}$) are/is compared with a first reference value ($X_{\text{ref},1}$) and the second measured voltage ($U_{\text{overcurrent},2}$) is compared with a second reference value ($X_{\text{ref},2}$), wherein the relevant turn-off semiconductor switch (2) is turned off or both semiconductor switches (2) are turned off in the event of the respective reference value ($X_{\text{ref},1}$, $X_{\text{ref},2}$) being exceeded.

4. Method according to Claim 3, wherein for selective protection the integral of the first measured voltage ($U_{\text{overcurrent},1}$) is compared with a first reference value ($X_{\text{ref},1}$) wherein the first reference value ($X_{\text{ref},1}$) is less than the second reference value ($X_{\text{ref},2}$).

5. Method according to any of Claims 1 to 4, wherein at the first semiconductor switch (2) a third voltage ($U_{\text{overcurrent},3}$) is additionally measured between the collector terminal (C) and the emitter terminal (E) and the first semiconductor switch (2) is turned off in the event of a third limit value ($X_{\text{ref},3}$) being exceeded.

6. Method according to any of Claims 1 to 5, wherein a current sensor is used as current sensing means, wherein independently of the measured voltages ($U_{\text{overcurrent},1}$, $U_{\text{overcurrent},2}$, $U_{\text{overcurrent},3}$) one of the turn-off semiconductor switches (2) or the turn-off semiconductor switches (2) is/are opened if the value sensed by the current sensor exceeds a limit value.

7. Electronic switch (1) for a DC voltage grid, comprising two turn-off semiconductor switches (2), wherein the two turn-off semiconductor switches (2) are arranged in such a way that they can each turn off a current having a different polarity through the electronic switch (1), wherein the two turn-off semiconductor switches (2) are arranged either in antiseries, in the case of reverse conducting semiconductor switches, or in antiparallel, in the case of reverse blocking semiconductor switches, in the electronic switch (1), wherein a first of the turn-off semiconductor switches (2) comprises at least four terminals (G, C, E, E'), wherein a second of the turn-off semiconductor switches (2) comprises at least three terminals (G, C, E), wherein the electronic switch comprises a voltage sensing means for measuring a first voltage ($U_{overcurrent,1}$) between an emitter terminal (E) and an auxiliary emitter terminal (E') at the first of the two turn-off semiconductor switches (2) and a second voltage ($U_{overcurrent,2}$) between a collector terminal (C) and an emitter terminal (E) or between a drain terminal and a source terminal at the second of the two turn-off semiconductor switches (2), wherein the electronic switch (1) comprises an evaluation unit (3) configured to compare the measured voltage ($U_{overcurrent,1}$, $U_{overcurrent,2}$) or the time integral of the measured voltage ($U_{overcurrent,1}$, $U_{overcurrent,2}$) in each case with a reference value ($X_{ref}$) and to turn off the relevant turn-off semiconductor switch (2) in the event of the reference value ($X_{ref}$) being exceeded.

8. DC voltage grid (4) comprising an electronic switch (1) according to Claim 7.

9. DC voltage grid (4) according to Claim 8, wherein the electronic switch (1) is arranged between a DC source (6) and a load (5) in such a way that a current from the DC source (6) to the load (5) is able to be turned off by means of the first semiconductor switch (2) and a current from the load (5) to the DC source (6) is able to be turned off by means of the second semiconductor switch (2).

10. DC voltage grid (4) according to either of Claims 8 and 9, wherein the evaluation unit (3) is configured, for selective protection, to compare the integral of the first measured voltage ($U_{overcurrent,1}$) with a first reference value ($X_{ref,1}$) and to compare the second measured voltage ($U_{overcurrent,2}$) with a second reference value ($X_{ref,2}$) and to turn off the relevant turn-off semiconductor switch (2) in the event of the respective reference value ($X_{ref,1}$, $X_{ref,2}$) being exceeded, wherein the first reference value ($X_{ref,1}$) is less than the second reference value ($X_{ref,2}$).

**Revendications**

1. Procédé de détection d'un courant de coupure par un commutateur électronique (1) pour un réseau en tension continue, dans lequel le commutateur électronique (1) présente deux commutateurs à semi-conducteur (2) pouvant être coupés, dans lequel les deux commutateurs à semi-conducteur (2) pouvant être coupés sont ainsi disposés qu'ils peuvent couper respectivement un courant de polarité différente par le commutateur électronique (1), dans lequel les deux commutateurs à semi-conducteur (2) pouvant être coupés sont disposés dans le commutateur électronique (1) soit en anti-série, en cas de commutateurs à semi-conducteur à conductivité inverse, soit en anti-parallèle, en cas de commutateurs à semi-conducteur à blocage inverse, dans lequel un premier des commutateurs à semi-conducteur (2) pouvant être coupés présente au moins quatre connexions (G, C, E, E'), dans lequel un deuxième des commutateurs à semi-conducteur (2) pouvant être coupés présente au moins trois connexions (G, C, E), dans lequel une première tension ($U_{Überstrom,1}$) est mesurée sur le premier des deux commutateurs à semi-conducteur (2) pouvant être coupés, entre une connexion émettrice (E) et une connexion émettrice auxiliaire (E') et une deuxième tension ($U_{Überstrom,2}$) est mesurée sur un deuxième des deux commutateurs à semi-conducteur (2) pouvant être coupés, entre une connexion collectrice (C) et une connexion émettrice (E) ou entre une connexion de drain et une connexion de source, dans lequel la tension mesurée ($U_{Überstrom,1}$, $U_{Überstrom,2}$) ou l'intégrale temporelle de la tension mesurée ($U_{Überstrom,1}$, $U_{Überstrom,2}$) est comparée respectivement à une valeur de référence ($X_{ref}$) et en cas de dépassement de la valeur de référence ($X_{ref}$), le commutateur à semi-conducteur (2) pouvant être coupé concerné est coupé.

2. Procédé selon la revendication 1, dans lequel une protection en fonction de la direction peut être réalisée avec différentes valeurs de référence.

3. Procédé selon l'une des revendications 1 ou 2, dans lequel, pour une protection sélective, la première tension mesurée ($U_{Überstrom,1}$) et/ou l'intégrale de la première tension mesurée ($U_{Überstrom,1}$) est comparée à une première valeur de référence ($X_{ref,1}$) et la deuxième tension mesurée ($U_{Überstrom,2}$) est comparée à une deuxième valeur de référence ($X_{ref,2}$), dans lequel en cas de dépassement de la valeur de référence respective ($X_{ref,1}$, $X_{ref,2}$), le commutateur à semi-conducteur (2) pouvant être coupé concerné est coupé ou bien les deux commutateurs à semi-conducteur (2) sont coupés.

**4.** Procédé selon la revendication 3, dans lequel, pour une protection sélective, l'intégrale de la première tension mesurée ($U_{\text{Überstrom}}$, 1) est comparée à une première valeur de référence ($X_{\text{ref}}$, 1), dans lequel la première valeur de référence ($X_{\text{ref}}$, 1) est inférieure à la deuxième valeur de référence ($X_{\text{ref}}$, 2).

**5.** Procédé selon l'une des revendications 1 à 4, dans lequel une troisième tension ($U_{\text{Überstrom}}$, 3) est mesurée en plus sur le premier commutateur à semi-conducteur (2), entre la connexion collectrice (C) et la connexion émettrice (E), et en cas de dépassement d'une troisième valeur limite ($X_{\text{ref}}$, 3), le premier commutateur à semi-conducteur (2) est coupé.

**6.** Procédé selon l'une des revendications 1 à 5, dans lequel un capteur de courant est employé en tant que moyen de détection du courant, dans lequel indépendamment des tensions mesurées ($U_{\text{Überstrom}}$, 1, $U_{\text{Überstrom}}$, 2, $U_{\text{Überstrom}}$, 3), un des commutateurs à semi-conducteur (2) pouvant être coupés ou bien les commutateurs à semi-conducteur (2) pouvant être coupés sont ouverts lorsque la valeur détectée par le capteur de courant dépasse une valeur limite.

**7.** Commutateur électronique (1) pour un réseau en tension continue présentant deux commutateurs à semi-conducteur (2) pouvant être coupés, dans lequel les deux commutateurs à semi-conducteur (2) pouvant être coupés sont ainsi disposés qu'ils peuvent couper respectivement un courant de polarité différente par le commutateur électronique (1), dans lequel les deux commutateurs à semi-conducteur (2) pouvant être coupés sont disposés dans le commutateur électronique (1) soit en anti-série, en cas de commutateurs à semi-conducteur à conductivité inverse, soit en anti-parallèle, en cas de commutateurs à semi-conducteur à blocage inverse, dans lequel un premier des commutateurs à semi-conducteur (2) pouvant être coupés présente au moins quatre connexions (G, C, E, E'), dans lequel un deuxième des commutateurs à semi-conducteur (2) pouvant être coupés présente au moins trois connexions (G, C, E), dans lequel le commutateur électronique présente une détection de tension pour mesurer une première tension ($U_{\text{Überstrom}}$, 1) entre une connexion émettrice (E) et une connexion émettrice auxiliaire (E') sur le premier des deux commutateurs à semi-conducteur (2) pouvant être coupés et une deuxième tension ($U_{\text{Überstrom}}$, 2) entre une connexion collectrice (C) et une connexion émettrice (E) ou entre une connexion de drain et une connexion de source sur le deuxième des deux commutateurs à semi-conducteur (2) pouvant être coupés, dans lequel le commutateur électronique (1) présente une unité d'évaluation (3) qui est conçue pour comparer la tension mesurée ($U_{\text{Überstrom}}$, 1, $U_{\text{Überstrom}}$, 2) ou l'intégrale temporelle de la tension mesurée ($U_{\text{Überstrom}}$, 1, $U_{\text{Überstrom}}$, 2), respectivement, à une valeur de référence ($X_{\text{ref}}$), et en cas de dépassement de la valeur de référence ($X_{\text{ref}}$), couper le commutateur à semi-conducteur (2) pouvant être coupé concerné.

**8.** Réseau en tension continue (4) comprenant un commutateur électronique (1) selon la revendication 7.

**9.** Réseau en tension continue (4) selon la revendication 8, dans lequel le commutateur électronique (1) est ainsi disposé entre une source CC (6) et une charge (5) qu'un courant de la source CC (6) vers la charge (5) peut être coupé au moyen du premier commutateur à semi-conducteur (2) et un courant de la charge (5) vers la source CC (6) peut être coupé au moyen du commutateur à semi-conducteur (2).

**10.** Réseau en tension continue (4) selon l'une des revendications 8 ou 9, dans lequel l'unité d'évaluation (3) est conçue, pour une protection sélective, pour comparer l'intégrale de la première tension mesurée ($U_{\text{Überstrom}}$, 1) à une première valeur de référence ($X_{\text{ref}}$, 1) et la deuxième tension mesurée ($U_{\text{überstrom}}$, 2) à une deuxième valeur de référence ($X_{\text{ref}}$, 2), et en cas de dépassement de la valeur de référence respective ($X_{\text{ref}}$, 1, $X_{\text{ref}}$, 2), pour couper le commutateur à semi-conducteur (2) pouvant être coupé concerné, dans lequel la première valeur de référence ($X_{\text{ref}}$, 1) est inférieure à la deuxième valeur de référence ($X_{\text{ref}}$, 2).

FIG 1

FIG 2

FIG 3

EP 3 857 690 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2013063188 A